# EUROPÄISCHE PATENTANMELDUNG

(11) **EP 1 734 577 A1**
(43) Veröffentlichungstag der Anmeldung: **20.12.2006**
(21) Anmeldenummer: 05405384.8
(22) Anmeldetag: 16.06.2005
(51) Int. Cl.: H01L 23/40, H01L 23/48

(54) **Kühlvorrichtung sowie Halbleitermodul mit einer solchen Kühlvorrichtung**

(71) Anmelder: ABB Research Ltd, 8050 Zürich (CH)
(72) Erfinder: Knapp, Wolfgang, 5600 Lenzburg (CH)
(74) Vertreter: ABB Patent Attorneys

(57) **Zusammenfassung**

Die erfindungsgemässe Kühlvorrichtung weist eine erste Platte (1) mit einer ersten Hauptseite (2a) und eine zweite Platte (4) mit einer ersten Hauptseite (5a), welche zweite Platte (4) als Kühlplatte ausgebildet ist, auf. Die beiden Platten (1, 4) sind an ihrer ersten Hauptseite (2a, 5a) miteinander verbunden und thermisch kontaktiert. Mindestens eine der ersten Hauptseite (2a, 5a) der ersten oder zweiten Platte (1, 4) weist mindestens eine Ausnehmung (3) und die jeweils andere Platte auf deren Hauptseite (5a, 2a) mindestens eine Ausstülpung (6) auf, wobei jede Ausstülpung (6) in eine Ausnehmung (3) eingreift und thermisch kontaktiert ist.

## Beschreibung

### Technisches Gebiet

Die Erfindung bezieht sich auf eine Kühlvorrichtung. Die erfindungsgemässe Kühlvorrichtung kann zur Kühlung von wärmeerzeugenden elektronischen Bauteilen wie Halbleitermodulen, aber auch zur Kühlung von wärmeerzeugenden Bauteilen in anderen technischen Gebieten eingesetzt werden. Die Erfindung geht von einer Kühlvorrichtung und einem Halbleitermodul gemäss den Oberbegriffen der unabhängigen Patentansprüche aus.

### Stand der Technik

Kühlvorrichtungen werden in Halbleitermodulen eingesetzt, um die in Halbleiterchips erzeugte Verlustwärme abzuführen. In der Druckschrift DE 44 43 611 A1 wird ein Hochleistungs-Thyristor beschrieben mit einem Keramik-Stützzylinder, in dem zwei aus massivem Kupfer bestehende Polstücke befestigt sind. Zwischen den zwei Polstücken ist ein Halbleiterplättchen angeordnet. Das Halbleiterplättchen weist Hauptelektroden auf seinen gegenüberliegenden Oberflächen auf. Die Anordnung bestehend aus dem Halbleiterplättchen und den zwei Polstücken wird unter hohem Druck zusammengepresst und an den koaxialen Enden des Keramik-Stützzylinders befestigt. Auf einer der Oberflächen des Halbleiterplättchens befindet sich ein Steueranschluss, welcher elektrisch isoliert von dem angrenzenden Polstück durch das Polstück und den Keramik-Stützzylinder hindurchgeführt wird. Das Halbleiterplättchen und die angrenzenden Bereiche der Polstücke werden von einem Lagefestlegungselement aus geformten Silikon umschlossen, um ihre Lage untereinander und bezüglich des Keramik-Stützzylinders zu fixieren. Jedoch muss jedes Halbleiterplättchen einzeln verpackt werden, was zu schweren und klobigen Systemen führt. Weitere Nachteile sind die hohe Genauigkeit bezüglich der Oberflächen der Polstücke und des Halbleiterplättchens und der hohe, dauerhaft erforderliche Anpressdruck, mit denen das Halbleiterplättchen mit den beiden Polstücken zusammengehalten werden muss, um einen guten thermischen und elektrischen Übergang zu schaffen.

Bei einer anderen Kühlvorrichtung für Halbleitermodule werden Halbleiterplättchen auf einer vorgebogenen Basisplatte angeordnet und diese mittels Schrauben auf einer Kühlplatte befestigt. Abhängig davon, wie die Basisplatte vorgebogen ist, entstehen mehrere Berührungspunkte verteilt über die Fläche der Basisplatte und an den Befestigungsstellen. Zwischen den Berührungspunkten entstehen Spalte zwischen den Platten, in den sich die Wärme staut. Im Falle unebener Oberflächen der Grund-und Kühlplatte verschlechtert sich der Kontakt zwischen der Grundplatte und Kühlplatte weiter, so dass die Verlustwärme schlechter abführbar ist. Durch die zum Pressen notwendigen Vorrichtungen sind diese Halbleitermodule sperrig.

### Darstellung der Erfindung

Aufgabe der Erfindung ist, eine Kühlvorrichtung anzugeben, welche eine verbesserte Kühlung gegenüber gängigen Kühlvorrichtungen aufweist. Fernerhin ist es Aufgabe der Erfindung, ein Halbleitermodul mit einer Kühlvorrichtung, welche eine verbesserte Kühlung gegenüber gängigen Kühlvorrichtungen aufweist, anzugeben.

Diese Aufgabe wird erfindungsgemäss durch eine Kühlvorrichtung mit den Merkmalen des unabhängigen Patentanspruchs 1, bzw. einem Halbleitermodul mit den Merkmalen des unabhängigen Patentanspruchs 11 gelöst.

Die erfindungsgemässe Kühlvorrichtung weist eine erste Platte mit einer ersten Hauptseite und einer ihr gegenüberliegenden zweiten Hauptseite und eine als Kühlplatte ausgebildete zweite Platte mit einer ersten Hauptseite und einer ihr gegenüberliegenden zweiten Hauptseite auf. Die erste Platte ist auf ihrer ersten Hauptseite mit der zweiten Platte auf deren ersten Hauptseite verbunden und thermisch kontaktiert. Die erste Hauptseite der ersten oder zweiten Platte weist mindestens eine Ausnehmung auf und die jeweils andere Platte weist auf ihrer ersten Hauptseite mindestens eine Ausstülpung auf, wobei jede Ausstülpung in jeweils eine Ausnehmung eingreift und thermisch kontaktiert ist. Durch die Ausstülpungen kann man eine grosse, formschlüssige Kontaktfläche zwischen der ersten und zweiten Platte erreichen und auch im Falle unebener Oberflächen der Platten werden die Platten in grösseren Bereichen als bei den Kühlvorrichtungen aus dem Stand der Technik thermisch kontaktiert. Durch die Ausstülpungen werden die Platten gegeneinander zumindest in einer Richtung ausgerichtet und sind gegen Bewegungen in dieser Richtung geschützt. Zwischen den beiden Platten sind keine zusätzlichen Schichten zur Verbindung der Platten erforderlich, welche den thermischen Übergang verschlechtern können und die zu Spannungen in den Platten im Falle unterschiedlicher Ausdehnung der Materialien bei Erwärmung führen können.

Ein erfindungsgemässes Halbleitermodul weist eine Kühlvorrichtung und mindestens einen Halbleiterchip mit einer Hauptseite auf. Der mindestens eine Halbleiterchip ist auf seiner Hauptseite mit der zweiten Hauptseite 2b der ersten Platte 1 der erfindungsgemässen Kühlvorrichtung verbunden und thermisch kontaktiert. Ein solches Halbleitermodul hat den Vorteil, dass die im Halbleiterchip erzeugte Verlustwärme durch die grossen Oberflächen der ersten und der zweiten Platte, die gute Kontaktierung beider Platten auch im Falle unebener Oberflächen und den geringen thermischen Widerstand zwischen den beiden Platten effizient abgeführt werden kann, so dass das Halbleitermodul bei hohen Leistungen betrieben werden kann.

Diese und weitere Aufgaben, Vorteile und Merkmale der vorliegenden Erfindung werden aus der nachfolgenden detaillierten Beschreibung von bevorzugten Ausführungsbeispielen der Erfindung in Verbindung mit den Zeichnungen offensichtlich.

### Kurze Beschreibung der Zeichnungen

Es zeigen:
- FIG. 1: ein Halbleitermodul mit einer Kühlvorrichtung nach dem Stand der Technik;
- FIG. 2: eine transparente Aufsicht auf eine erfindungsgemässe Kühlvorrichtung vor dem Zusammensetzen der Grundplatte und der Kühlplatte;
- FIG. 3 bis 6eine: Aufsicht auf unterschiedliche Ausführungsformen einer erfindungsgemässe ersten oder zweiten Platte der erfindungsgemässen Kühlvorrichtung; und
- FIG. 7: einen Querschnitt einer weiteren Ausführungsform der erfindungsgemässen Kühlvorrichtung.

Die in den Zeichnungen verwendeten Bezugszeichen sind in der Bezugszeichenliste zusammengefasst aufgelistet. Grundsätzlich sind in den Zeichnungen gleiche Teile mit gleichen Bezugszeichen versehen. Die beschriebenen Ausführungsformen stehen beispielhaft für den Erfindungsgegenstand und haben keine beschränkende Wirkung.

### Wege zur Ausführung der Erfindung

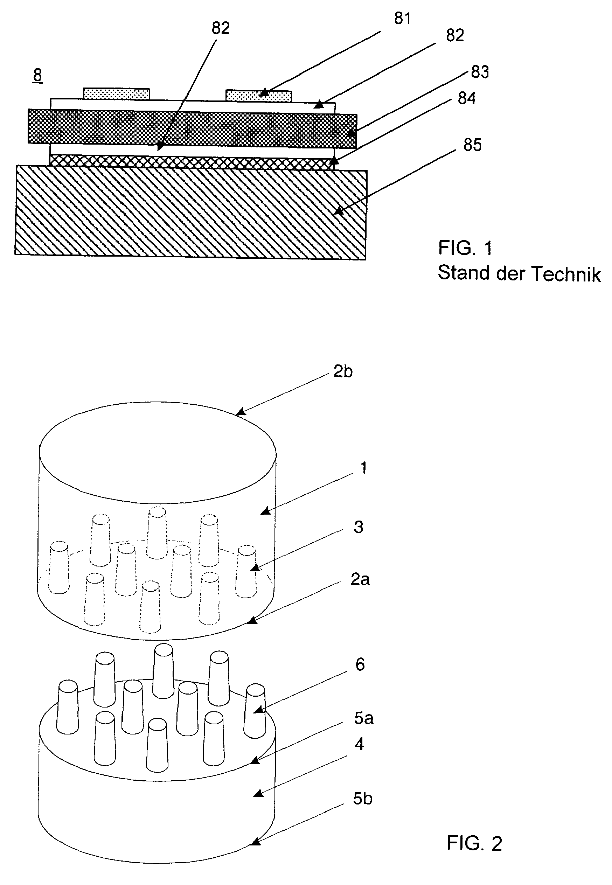

In FIG. 1 ist ein Halbleitermodul 8 nach dem Stand der Technik mit einer konventionellen Kühlvorrichtung dargestellt. In dem Halbleitermodul sind mehrere Halbleiterchips 81 auf der Oberseite eines Keramiksubstrats 83, welches auf der Oberseite und der ihr gegenüberliegenden Unterseite Metallisierungen 82 aufweist, angeordnet. Auf der Unterseite des Keramiksubstrats ist eine Lotschicht 84 angeordnet, durch welche das Keramiksubstrat 83 mit einer Kühlplatte 85 verbunden ist.

FIG. 2 stellt eine erfindungsgemässe Kühlvorrichtung vor dem Zusammensetzen dar. Die Kühlvorrichtung umfasst eine erste Platte 1 mit einer ersten Hauptseite 2a und einer ihr gegenüberliegenden zweiten Hauptseite 2b. Eine zweite Platte 4 ist als Kühlplatte ausgebildet und weist eine erste Hauptseite 5a und eine ihr gegenüberliegenden zweite Hauptseite 5b auf. Die erste und zweite Platte 1, 4 sind auf ihren ersten Hauptseiten 2a, 5a miteinander verbunden und thermisch kontaktiert. Die erste oder zweite Platte 1, 4 weist auf ihrer ersten Hauptseite 2a, 5a mindestens eine Ausnehmung auf und die jeweils andere Platte 1, 4 weist mindestens eine Ausstülpung auf, wobei jede Ausstülpung 6 in jeweils eine Ausnehmung 3 eingreift und thermisch kontaktiert ist. Der Wärmeaustausch zwischen der ersten und der zweiten Platte 1, 4 erfolgt durch die Ausnehmungen und Ausstülpungen 3, 6 über eine grössere Fläche als bei ebenen Platten, so dass die Wärmeübertragungskapazität in der Kühlvorrichtung verbessert wird. Auch im Falle einer unebenen ersten Hauptseite 2a und / oder 5a kann durch eine derartige Ausbildung der Platten 1, 4 mit Ausstülpungen 6, bzw. Ausnehmungen 3 eine gute thermische Kontaktierung erreicht werden. Die als Kühlplatte ausgebildete zweite Platte 4 kann an ihrer zweiten Hauptseite 5b mit Kühlrippen verbunden sein oder einstückig als Kühlplatte mit Kühlrippen ausgebildet sein. Die Kühlung kann verstärkt werden, wenn durch solche Kühlrippen ein Kühlfluid (eine Kühlflüssigkeit oder ein Gas wie beispielsweise Luft) fliesst.

In einer Variante zu der in FIG. 2 dargestellten Ausführungsform weist jede der Platten 1, 4 sowohl Ausnehmungen 3 wie auch Ausstülpungen 6 auf. Bei dieser Variante findet der Wärmeaustausch über einen grösseren Tiefenbereich statt und die Platte 1, 4 werden gut gegeneinander ausgerichtet.

In einer weiteren Ausführungsform des erfindungsgemässen Gegenstands wird der thermische Kontakt zwischen der ersten und zweiten Platte 1, 4 durch Aufbringen einer Wärmeleitpaste zwischen den beiden Platten 1, 4 weiter verbessert.

Es ist auch denkbar, dass die Platten 1, 4 lösbar miteinander verbunden sind, indem beispielsweise die Platten 1, 4 durch eine Klemm- oder Spannvorrichtung oder mittels Schrauben miteinander verbunden sind. Zu Wartungs- oder Reparaturzwecken kann die Verbindung zwischen den Platten 1, 4 auf einfache Weise gelöst werden.

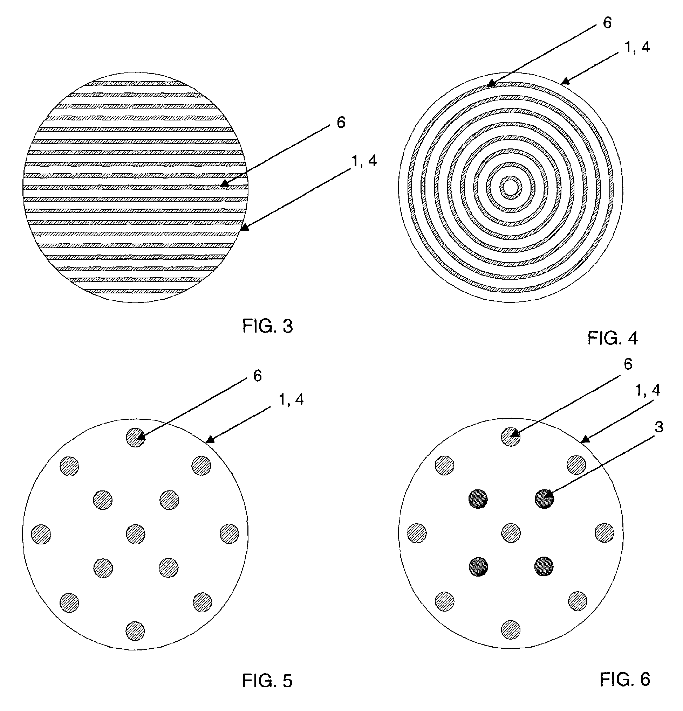

Bei der erfindungsgemässen Kühlvorrichtung können die erste Platte 1 und die zweite Platte 4 aus einem Metall oder einer Metalllegierung gefertigt sein. Es eignen sich beispielsweise Aluminium oder Kupfer oder eine Legierung, welche Aluminium oder Kupfer enthält, weil sie eine gute thermische Leitfähigkeit aufweisen, kostengünstig sind und zur Herstellung der Kühlvorrichtung einfach zu bearbeiten sind. Zur Erzeugung von Ausstülpungen und / oder Ausnehmungen können solche Metalle oder Metalllegierungen beispielsweise mit einem Elektronenstrahl bearbeitet werden, indem durch den Elektronenstrahl das Metall oder die Legierung lokal um den Elektronenstrahl herum erwärmt wird und es noch in der flüssigen Phase verschoben wird, so dass sich Ausnehmungen an den Stellen ausbilden, an denen das Metall oder die Legierung verflüssigt wird und Ausstülpungen an den Stellen, zu denen das Material verschoben wird. Dieser Schritt lässt sich aus unterschiedlichen Richtungen wiederholen, so dass unterschiedliche Oberflächenstrukturen wie in den FIG. 3 bis 7 dargestellt, ausgebildet werden können. Mit diesem Verfahren können Strukturen mit einer Höhe von bis zu 2 mm und einer Breite von bis zu 2 mm geschaffen werden. Die Strukturen können mit diesem Verfahren preiswert und schnell erzeugt werden. Die Bearbeitungsdauer für die Ausbildung von Strukturen für eine Platte dauert typischerweise nur wenige Sekunden, beispielsweise etwa 10 s. Es ist möglich, die Strukturen bei bestehenden Bauteilen nachträglich auszubilden, da die Bauteile zur Bearbeitung nicht eingespannt zu werden brauchen. Somit wird auch die Gefahr des Brechens des Bauteils bei der Bearbeitung minimiert. Die erste und die zweite Platte 1, 4 können auch aus demselben Metall gefertigt sein, so dass keine unterschiedlichen Ausdehnungen in den Platten 1, 4 bei Erwärmung auftreten können. Vorteilhaft ist es auch, die erste und / oder die zweite Platte 1, 4 aus einem Metall-Matrix Verbundwerkstoff wie beispielsweise AlSiC, CuMo oder Al-Graphit zu fertigen, weil derartige Verbundstoffe einen niedrigen thermischen Ausdehnungskoeffizienten aufweisen. Es sind aber auch denkbar, die erste Platte 1 aus einem Keramiksubstrat wie einer Aluminiumnitrid-Keramik zu fertigen. Im Falle einer Verwendung der erfindungsgemässen Kühlvorrichtung in einem Halbleitermodul hat ein Keramiksubstrat den Vorteil, dass sein Ausdehnungskoeffizient sich nicht wesentlich von dem des Halbleiterchips unterscheidet.

Im folgenden werden einige unterschiedliche Ausbildungen der Ausstülpungen 6 der ersten Hauptseiten 2a, 5a einer der ersten oder zweiten Platte 1, 4 ausgeführt. Die jeweils andere Platte 1, 4 ist auf ihrer ersten Hauptseite 2a, 5a derart mit Ausnehmungen 3 versehen, dass jede Ausstülpung 6 in eine Ausnehmung 3 greift. Bei jeder dieser Ausbildungen ist es denkbar, dass auf den ersten Hauptseiten 2a, 5a beider Platten 1, 4 Ausstülpungen 6 und Ausnehmungen 3 ausgebildet sind. Wenn benachbarte Gebiete der ersten Hauptseite 2a, 5a abwechselnd Ausstülpungen 6 und Ausnehmungen 3 aufweisen, erfolgt der Wärmeübergang über einen grösseren Tiefenbereich, so dass die Kühlung verbessert wird.

In FIG. 3 ist eine weitere Ausführungsform der Kühlvorrichtung dargestellt. In FIG. 3 sind die Ausstülpungen 6 der ersten Hauptseite 2a, 5a rillenförmig und parallel zueinander ausgebildet. Die rillenförmigen Ausstülpungen in FIG. 3 sind linear angeordnet, so dass die erste und zweite Platte 1, 4 in der Richtung senkrecht zu den rillenförmigen Ausstülpungen gegeneinander ausgerichtet sind. Eine Verschiebung der Platten gegeneinander ist nur in Längsrichtung der rillenförmigen Ausstülpungen möglich.

In einer der Übersichtlichkeit halber nicht dargestellten Variante sind die rillenförmigen Ausstülpungen in Wellenlinien angeordnet, wodurch die Platten nicht mehr gegeneinander verschieblich sind.

In FIG. 4 ist eine weitere Ausführungsform der Kühlvorrichtung dargestellt. In FIG. 4 sind rillenförmige Ausstülpungen 6 kreisförmig und konzentrisch angeordnet, so dass die Platten 1, 4 nicht gegeneinander verschieblich sind. Bei den Ausführungsformen gemäss der FIG. 3 und 4 weisen die ersten Hauptseiten 2a, 5a eine grosse Oberfläche auf, so dass ein guter Wärmeübergang stattfindet. Auch andere Ausführungsformen wie eine zickzackförmige Anordnung der rillenförmigen Ausstülpungen 6 oder eine Kombinationen der aufgeführten Ausstülpungsformen ist denkbar.

In FIG. 5 ist eine weitere Ausführungsform der Kühlvorrichtung dargestellt. Dabei weist die erste Hauptseite 2a, 5a der ersten oder zweiten Platte 1, 4 fingerartige Ausstülpungen auf. Dadurch lassen sich die Platten 1, 4 einfach gegeneinander ausrichten und die Ausstülpungen 6 bzw. Ausnehmungen 3 sind einfach herzustellen.

In FIG. 6 ist eine Variante zu der in FIG. 5 dargestellten Ausführungsform gezeigt. Die erste und zweite Platte 1, 4 weisen Ausstülpungen 6 und Ausnehmungen 3 auf, welche abwechselnd angeordnet sein können, damit der Wärmeübergang auf einem möglichst grossen Tiefenbereich stattfindet.

Es ist auch denkbar, statt der einstückig mit der ersten und / oder zweiten Platte ausgebildeten Ausstülpungen 6 beide Platten 1, 4 auf ihrer ersten Hauptseite 2a, 5a mit fingerartigen Ausnehmungen 3 auszugestalten, wobei die Ausnehmungen 3 beim Zusammensetzen der Platten 1, 4 aneinander stossen und die beiden Platten 1, 4 über Stifte mit einer Länge, welche höchstens der Summe der Tiefen der jeweils aneinander stossenden Ausnehmungen 3 entspricht, verbunden werden.

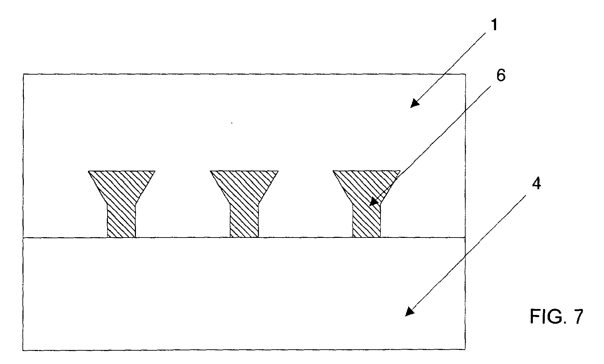

In FIG. 7 ist ein Querschnitt einer weiteren Ausführungsform der Kühlvorrichtung dargestellt, bei der die zweite Platte 4 rillenförmige Ausstülpungen 6, welche linear angeordnet sind, aufweist wie auch schon in FIG. 2 dargestellt. Die Ausstülpungen 6 sind am Ende trapezförmig erweitert, so dass die Platten 1, 4 beim Zusammenbau von einer Seite ineinander schiebbar sind und die Platten miteinander verhaken. Eine solche Verbindung ist mechanisch stabil gegen Bewegungen der Platten 1, 4 voneinander weg und gegen seitliche Bewegungen senkrecht zu den Rillen. Im Falle von Reparaturen oder Wartungen lassen sich die Platten 1, 4 einfach voneinander lösen, indem sie wieder gegeneinander zur Seite in Richtung der Rillen verschoben werden. Statt einer trapezförmigen Erweiterung können die Ausstülpungen auch zu ihrem Ende hin zu einer Seite gebogen oder abgewinkelt sein. Es ist auch jegliche andere Form der Ausstülpung 6 oder Ausnehmung 3 denkbar, bei der in bezug auf eine senkrecht auf der Hauptseite 2a, 5a stehenden Achse der Ausstülpung 6 oder Ausnehmung 3 bei einem Schnitt durch die Ausstülpung 6 oder die Ausnehmung 3 parallel zu der Hauptseite 2a, 5a zumindest an einem Ort die Ausstülpung 6 oder die Ausnehmung 3 breiter ist als auf einem näher an der Hauptseite 2a, 5a gelegenen Ort.

Bei jeder der bisher dargestellten erfindungsgemässen Ausführungsformen ist es auch denkbar, dass die erste und zweite Platte 1, 4 elektrisch leitend und elektrisch kontaktiert sind. Dies ist wichtig bei Anwendungen, in denen durch die Kühlvorrichtung Strom geführt werden soll.

Die erfindungsgemässe Kühlvorrichtung lässt sich beispielsweise in einem Halbleitermodul, insbesondere einem Leistungshalbleitermodul mit mindestens einem Halbleiterchip, welcher eine Hauptseite aufweist, einsetzen. Die Hauptseite des Halbleiterchips ist mit der zweiten Hauptseite 2b der ersten Platte 1 verbunden und thermisch kontaktiert. Die zweite Platte 4 kann auf der zweiten Hauptseite mit Kühlrippen ausgestattet sein, durch die ein Kühlfluid (Kühlflüssigkeit oder ein Gas) strömt und somit die Verlustwärme von dem Halbleiterchip abführt. Zwischen den Platten 1, 4 ist ein guter Wärmeübergang erforderlich, damit es nicht zu einem Wärmestau kommt. Mit der erfindungsgemässen Kühlung lässt sich die Wärme schneller vom mindestens einen Halbleiterchip abführen, so dass das Halbleitermodul bei höheren Leistungen betrieben werden kann. Bei einigen Halbleitermodulen wird die Kühlplatte 4 als eine Hauptelektrode verwendet. In diesem Falle können die erste und die zweite Platte 1, 4 elektrisch leitend ausgebildet und elektrisch kontaktiert sein sowie der mindestens eine Halbleiterchip mit der ersten Platte 1 elektrisch kontaktiert sein, so dass Strom durch die zweite Platte 4 zum Halbleiterchip fliessen kann. Es ist keine zusätzliche elektrisch leitende Schicht zwischen der ersten und der zweiten Platte 1, 4 erforderlich, welche die thermische Leitfähigkeit verschlechtern könnte.

In einer weiteren, der Übersichtlichkeit halber nicht dargestellten Ausführungsform umfasst das Leistungshalbleitermodul mindestens zwei Kühlvorrichtungen und mindestens einen Halbleiterchip, welcher auf der Hauptseite und einer weiteren, der Hauptseite gegenüberliegenden Seite mit je einer erfindungsgemässen Kühlvorrichtung verbunden ist, wobei der Halbleiterchip mit je einer ersten Platte 1 auf deren zweiten Hauptseite 2b verbunden und thermisch kontaktiert ist. In dieser Ausführungsform wird der Halbleiterchip von zwei gegenüberliegenden Seiten gekühlt, so dass eine effiziente Kühlung erfolgt.

### Bezugszeichenliste

- 1: erste Platte
- 2a: erste Hauptseite der ersten Platte
- 2b: zweite Hauptseite der ersten Platte
- 3: Ausnehmung
- 4: zweite Platte
- 5a: erste Hauptseite der zweiten Platte
- 5b: zweite Hauptseite der zweiten Platte
- 6: Ausstülpung
- 8: Halbleitermodul
- 81: Halbleiterchip
- 82: Metallisierung
- 83: Grundplatte
- 84: Lotschicht
- 85: Kühlplatte

## Patentansprüche

1. Kühlvorrichtung, umfassend eine erste Platte (1) mit einer ersten Hauptseite (2a) und einer ihr gegenüberliegenden zweiten Hauptseite (2b) und eine zweite Platte (4), welche zweite Platte (4) als Kühlplatte ausgebildet ist und eine erste Hauptseite (5a) und eine ihr gegenüberliegenden zweite Hauptseite (5b) aufweist, wobei die erste Platte (1) an ihrer ersten Hauptseite (2a) mit der zweiten Platte an deren ersten Hauptseite (5a) verbunden und thermisch kontaktiert ist, **dadurch**
**gekennzeichnet, dass**
die erste Hauptseite (2a, 5a) der ersten oder zweiten Platte (1, 4) mindestens eine Ausnehmung (3) aufweist, und dass die jeweils andere Platte (1, 4) auf deren Hauptseite (5a, 2a) mindestens eine Ausstülpung (6) aufweist, wobei jede Ausstülpung (6) in jeweils eine Ausnehmung (3) eingreift und thermisch kontaktiert ist.

2. Kühlvorrichtung nach Anspruch 1, **dadurch gekennzeichnet, dass** die erste und die zweite Platte (1, 4) jeweils mindestens eine Ausnehmung (3) und mindestens eine Ausstülpung (6) aufweisen und jede Ausstülpung (6) in jeweils eine Ausnehmung (3) eingreift und thermisch kontaktiert ist.

3. Kühlvorrichtung nach Anspruch 1 oder 2, **dadurch gekennzeichnet, dass** mindestens eine Ausstülpung eine Höhe bis zu 2 mm und eine Breite bis zu 2 mm aufweist.

4. Kühlvorrichtung nach einem der Ansprüche 1 bis 3, **dadurch**
**gekennzeichnet, dass**
die erste Platte (1) und die zweite Platte (4) lösbar verbunden sind.

5. Kühlvorrichtung nach einem der Ansprüche 1 bis 3, **dadurch**
**gekennzeichnet, dass**
die erste Platte (1) und die zweite Platte (4) elektrisch kontaktiert sind.

6. Kühlvorrichtung nach einem der Ansprüche 1 bis 3, **dadurch**
**gekennzeichnet, dass**
die erste Platte (1) und die zweite Platte (4) aus einem Metall, insbesondere aus Aluminium oder Kupfer, einer Metalllegierung oder einem Metall-Matrix Verbundwerkstoff gefertigt sind.

7. Kühlvorrichtung nach Anspruch 6, **dadurch gekennzeichnet, dass**
die erste Platte (1) und die zweite Platte (4) aus demselben Material angefertigt sind.

8. Kühlvorrichtung nach einem der Ansprüche 1 bis 3, **dadurch**
**gekennzeichnet, dass**
mindestens eine Ausstülpung (6) rillenförmig ausgebildet ist.

9. Kühlvorrichtung nach Anspruch 8, **dadurch gekennzeichnet, dass** mindestens eine rillenförmige Ausstülpung (6) kreisförmig angeordnet ist.

10. Kühlvorrichtung nach einem der Ansprüche 1 bis 3, **dadurch**
**gekennzeichnet, dass**
mindestens eine Ausstülpung (6) fingerartig ausgebildet ist.

11. Halbleitermodul, umfassend mindestens einen Halbleiterchip mit mindestens einer Hauptseite, **dadurch gekennzeichnet, dass** eine Kühlvorrichtung nach einem der vorangegangenen Ansprüche vorgesehen ist, und dass der Halbleiterchip auf seiner Hauptseite mit der ersten Platte (1) auf deren zweiten Hauptseite (2b) verbunden und thermisch kontaktiert ist.

12. Halbleitermodul nach Anspruch 11, **dadurch gekennzeichnet, dass** mindestens zwei Kühlvorrichtungen nach einem der vorangegangenen Ansprüche vorgesehen sind und dass der mindestens eine Halbleiterchip eine weitere, der Hauptseite gegenüberliegende Seite aufweist und dass der mindestens eine Halbleiterchip auf seiner Hauptseite und seiner weiteren Seite mit je einer ersten Platte (1) auf deren zweiten Hauptseite (2b) verbunden und thermisch kontaktiert ist.

13. Halbleitermodul nach Anspruch 11, **dadurch gekennzeichnet, dass** der mindestens eine Halbleiterchip mit der ersten Platte (1) elektrisch kontaktiert ist.
